# FASCICULE DE BREVET EUROPEEN

(11) **EP 1 556 832 B1**
(45) Date de publication et mention de la délivrance du brevet: **20.12.2006**
(21) Numéro de dépôt: 03778441.0
(22) Date de dépôt: 23.10.2003
(51) Int. Cl.: G06K 19/077

(54) **CARTE A PUCE COMPORTANT UN COMPOSANT DEBOUCHANT ET UN PROCEDE DE FABRICATION**
CHIPKARTE MIT EINEM AUFTAUCHENDEN BAUELEMENT UND HERSTELLUNGSVERFAHREN
SMART CARD COMPRISING A PROTRUDING COMPONENT AND METHOD FOR MAKING SAME

(30) Priorité: 28.10.2002 FR 0213465
(43) Date de publication de la demande: 27.07.2005
(73) Titulaire: OBERTHUR CARD SYSTEMS SA, 75017 Paris (FR)
(72) Inventeur: LAUNAY, François, F-14610 Epron (FR); VENAMBRE, Jacques, F-14123 Ifs (FR)
(74) Mandataire: Quantin, Bruno Marie Henri
(86) Numéro de dépôt international: PCT/FR2003/003139
(87) Numéro de publication internationale: WO 2004/040507

(56) Documents cités:
- EP-A- 0 234 954
- FR-A- 2 662 896
- FR-A- 2 776 796

## Description

L'invention concerne une carte à puce incorporant un microcircuit (ou circuit intégré) muni de contacts extérieurs ainsi qu'au moins un autre composant dont un composant débouchant, tel qu'un afficheur, un détecteur (par exemple un détecteur d'empreintes digitales) ou un émetteur (par exemple un émetteur optique) c'est à dire un composant devant émerger (sans nécessairement venir en saillie) de la surface de la carte.

Une manière classique de fabriquer une carte à puce comportant un simple microcircuit à microprocesseur consiste à réaliser une cavité dans le support (en pratique en plastique) de la carte et à y coller un module constitué du microcircuit à microprocesseur et des contacts externes reliés à ce microcircuit. On peut se référer à cet égard au document US-6 372 541.

Dans le cas où la carte à puce est destinée à comporter, en complément d'un module à microcircuit (formant avec une antenne un ensemble appelé interface de communication), un autre composant électronique qui débouche en surface, il a été proposé par le document WO-99/50790, de connecter le composant électronique à l'interface de communication au moyen de fils conducteurs, de fixer provisoirement l'ensemble ainsi réalisé contre une première plaquette de matière plastique, de placer une deuxième plaquette de matière plastique sur cet ensemble, une ouverture étant prévue soit dans la première plaquette soit dans la seconde plaquette pour servir de logement au composant électronique, puis de solidariser les deux plaquettes en enfermant l'interface et le composant électronique.

Cette méthode nécessite des équipements spécifiques pour positionner l'ensemble au milieu de la structure plastique avant la réalisation finale et ménager les ouvertures adéquates dans les plaquettes. En outre, l'interface de communication et le composant débouchant en surface doivent pouvoir supporter les températures auxquelles est réalisée la solidarisation des plaquettes ; or les températures où est réalisée cette solidarisation sont typiquement au moins égales à 140°C, par exemple dans le cas d'une lamination des plaquettes comme le propose le document précité.

Par ailleurs, les documents EP-0 908 844 et US-6 320 753, concernant une invention antérieure de la Demanderesse, proposent une carte à puce combinant des plages de contact extérieur et une antenne, comprenant un microcircuit connecté à la fois à l'antenne par des bornes de connexion et aux plages de contact extérieur par d'autres bornes de connexion, l'antenne étant disposée entre un support et une plaquette, et les bornes de connexion étant disposées en vis-à-vis des extrémités de raccordement correspondantes du microcircuit. Le microcircuit et l'antenne sont montés séparément, et on retrouve la notion d'interposition entre une plaquette et un support.

Une telle configuration en sandwich se retrouve dans le document EP - 0 234 954 qui décrit une carte à puce formée d'une carte PC entre deux plaquettes, ou encore dans le document US-5 412 192 concernant une carte dans le support de laquelle est noyée une antenne et dans laquelle un élément de visualisation est laminé à l'intérieur de cette carte.

Comme indiqué à propos du premier document, les diverses solutions sont complexes et leur mise en oeuvre implique souvent des traitements dont il faut s'assurer qu'ils peuvent être subis sans dommage par les composants.

L'invention a pour objet une carte à puce comportant un microcircuit ainsi qu'au moins un autre composant dont un composant débouchant, dont la fabrication soit simple et fiable, sans nécessiter de traitements agressifs vis-à-vis des composants ni conduire à un affaiblissement mécanique de la carte, et dans laquelle les éventuels efforts de flexion appliqués à la carte soient avantageusement localisés en des endroits où ils n'ont que peu de conséquences.

L'invention a également pour objet un procédé de fabrication d'une telle carte à puce.

L'invention propose à cet effet une carte à puce comportant un microcircuit, au moins un autre composant dont un composant débouchant et des contacts extérieurs dans un support de carte, caractérisée en ce que le microcircuit, le composant débouchant et les contacts extérieurs font partie d'un sous-ensemble fixé dans un logement ménagé dans une partie de l'épaisseur du support de carte, ce sous-ensemble comportant un film support portant sur une face interne le microcircuit et au moins le composant débouchant et sur une face externe les contacts extérieurs, une fenêtre étant ménagée dans ce film support en regard d'une partie du composant débouchant.

Pour la fabrication d'une telle carte à puce, l'invention propose en outre un procédé de fabrication d'une carte à puce comportant un microcircuit et au moins un autre composant dont un composant débouchant, comportant les étapes suivantes :
- assemblage d'un sous-ensemble par montage sur un film support du microcircuit et d'au moins le composant débouchant, en ménageant dans ce film une fenêtre pour l'accès au composant débouchant, et en assurant les connexions au moyen de fils de connexion,
- aménagement d'un logement dans le support de carte,
- fixation du sous-ensemble dans le logement.

On appréciera que l'invention propose une solution simple au problème de la fabrication d'une carte à puce comportant un microcircuit à microprocesseur muni de ses contacts extérieurs ainsi qu'au moins un composant débouchant, puisqu'elle propose d'utiliser des techniques bien connues ayant fait leurs preuves, selon lesquelles on réalise les connections par des fils entre des éléments logés dans une (ou plusieurs) cavité(s) ménagées dans une partie de l'épaisseur du support de la carte ; en outre le fait de prévoir un sous-ensemble formé des éléments à monter dans la (ou les) cavité(s) permet de réaliser facilement les opérations de montage et de connexion indépendamment du (ou des) logement(s) dans le support.

Selon des enseignements préférés de l'invention, éventuellement combinés :
- le sous-ensemble comporte en outre un composant d'interface connecté entre le microcircuit et le composant débouchant ; l'invention s'applique en effet à un nombre quelconque de composants en plus du composant microcircuit; cet autre composant peut notamment être un pilote pour le composant débouchant,
- les connexions au sein du sous-ensemble sont réalisées par des fils de connexion, ce qui correspond à un mode bien maîtrisé de connexion électrique,
- ces fils de connexion sont chacun fixés, d'une part, au microcircuit ou à un composant, d'autre part, à une piste de connexion portée par le film support,
- le logement comporte au moins une cavité dans laquelle est fixée le microcircuit et une cavité dans laquelle est fixé le composant débouchant, au moins une nervure étant prévue entre les cavités,
- le film support comporte une zone mécaniquement affaiblie en flexion entre au moins le microcircuit et un composant, adaptée à porter contre une nervure ; une telle zone mécaniquement affaiblie est avantageusement ménagée de part et d'autre du microcircuit et de chaque autre composant,
- d'autres zones mécaniquement affaiblies peuvent être disposées transversalement aux premières, ce qui améliore encore plus la flexibilité du sous-ensemble, chaque zone mécaniquement affaiblie comporte de préférence au moins une fente,
- des pistes de connexion sont ménagées entre le microprocesseur et chaque composant, chacune en regard d'une nervure, chaque piste étant traversée par au moins une zone mécaniquement affaiblie,
- le film support comporte des zones mécaniquement affaiblies qui sont parallèles, voire de telles zones qui sont disposées selon au moins deux directions,
- chaque cavité est remplie d'un matériau rigide contenant le microcircuit ou un autre composant et s'étendant jusqu'au film support,
- chaque cavité est munie à la périphérie de son fond d'au moins une dépression.

Par analogie avec ce qui vient d'être exposé à propos de la carte à puce de l'invention, le procédé de fabrication de celle-ci comporte avantageusement les dispositions suivantes, éventuellement combinées:
- on aménage dans le logement une cavité pour le microcircuit et une cavité pour le composant débouchant,
- on aménage dans le film support des zones mécaniquement affaiblies en flexion au moins entre le microcircuit et le composant débouchant,
- on aménage dans le film support des zones mécaniquement affaiblies en flexion de part et d'autre du microcircuit et de chaque composant; on peut aménager en outre d'autres zones mécaniquement affaiblies en flexion qui sont transversales (par exemple perpendiculaires) aux premières,
- on aménage les zones mécaniquement affaiblies en flexion au moyen de fentes,
- au moins une zone mécaniquement affaiblie en flexion est disposée en regard d'une nervure ménagée dans le logement entre deux cavités
- des pistes de connexion connectées au moyen de fils au microcircuit ou à un composant sont traversées par les zones mécaniquement affaiblies en flexion,
- au moins une dépression est ménagée à la périphérie du fond d'au moins une cavité,
- on aménage dans le film support une pluralité de zones mécaniquement affaiblies en flexion qui sont parallèles, ou une pluralité de zones mécaniquement affaiblies qui sont disposées selon au moins deux directions.

Des objets, caractéristiques et avantages de l'invention ressortent de la description qui suit, donnée à titre d'exemple illustratif non limitatif en regard des dessins annexés sur lesquels :
- la figure 1 est une vue du sous-ensemble formé des divers composants, du côté interne,
- la figure 2 est une vue de dessus de la carte obtenue à partir de ce sous-ensemble, celui-ci étant vu du côté opposé à celui de la figure 1,
- la figure 3 est une vue de dessous, analogue à celle de la figure 1, d'un sous-ensemble selon une variante préférée de réalisation de l'invention,
- la figure 4 est une vue en coupe de ce sous-ensemble en place au-dessus d'une pluralité de cavités ménagées dans un support de carte,
- la figure 5 est une vue analogue à celle de la figure 4, après remplissage des cavités avec une résine de fixation, et
- la figure 6 est une vue de détail d'une cavité selon encore une autre variante de réalisation.

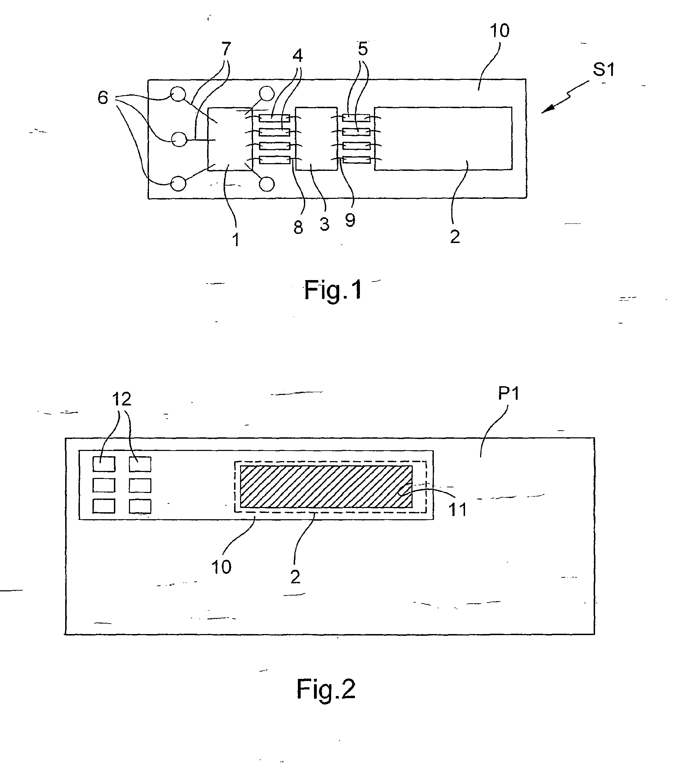

Les figures 1 et 2 représentent un sous-ensemble S1, pris isolément ou au sein d'une carte à l'état fini.

Ce sous-ensemble S1 comporte un microcircuit 1 comportant en pratique microprocesseur, un composant débouchant 2 et, ici, un composant d'interface 3, par exemple un pilote du composant débouchant 2. Ce composant débouchant 2 est par exemple un dispositif d'affichage mais peut être de toute autre nature, par exemple un composant de détection ou d'émission destiné à être intégré à la carte.

Entre les éléments sont ici montées des pistes ou bandes de connexion 4 et 5, tandis que des plots de connexion 6 sont disposés autour du microcircuit 1. Le microcircuit 1 est, d'une-part, relié aux plots de connexion au moyen de fils de connexion 7 et, d'autre part, au composant d'interface 3 via les pistes de connexion 4 par l'intermédiaire de fils de connexion 8, tandis que ce composant d'interface est relié au composant débouchant 2 via les pistes de connexion 5 par d'autres fils de connexion 9.

Ces composants 1, 2 et 3 ainsi que les pistes de connexion 4 et 5 sont montés sur un film support 10 dans lequel est ménagée une fenêtre 11. Sur la face opposée de celle sur laquelle sont montés ces éléments sont disposés des contacts extérieurs 12 reliés aux plots de connexion 6 par des moyens non représentés. En variante-non représentée, les plots 6 sont omis et le microcircuit est directement relié aux contacts extérieurs 12, les fils de connexion traversant, de manière connue en soi, le film support 10 (la référence 6 désigne alors les perçages du support de carte par lesquels les fils traversent le film support). Selon une autre variante non représentée, les pistes de connexion 4 et 5 peuvent être omises, les fils de connexion 8 et 9 réalisant une connexion directe du microcircuit au composant d'interface, et de celui-ci au composant débouchant. Un intérêt de ces pistes de connexion est de raccourcir les fils 8 et 9. Un autre avantage ressortira des figures suivantes.

La fenêtre 11 est de plus faible section que celle du composant d'interface, de sorte que celui-ci reste en contact avec le film support 10 par au moins une partie de sa périphérie. Dans l'exemple considéré, le composant resté en contact avec ce film support sur toute sa périphérie, mais en variante il peut notamment n'être en contact avec ce film que par ses extrémités.

Alors que de manière classique on considère souvent un module formé d'un fin support portant sur une face le microcircuit et sur une autre face ses contacts extérieurs, on utilise selon l'invention un module plus grand puisqu'il comporte d'autres composants, ici tous les autres composants électroniques.

Les composants peuvent être fixés sur le film support par tous moyens connus appropriés, par exemple par collage ou par adhésif. En ce qui concerne les pistes de connexion, les éventuels plots de connexion et les contacts extérieurs, ils peuvent être obtenus notamment par dépôt métallique, ou par tout autre moyen approprié.

Le sous-ensemble occupe de préférence sensiblement toute la surface du logement qui est ménagé dans le support de carte P1.

Ce sous-ensemble peut être monté dans une cavité unique, en y étant fixé par une colle, ou, de la même manière que l'on fixe les modules simplement constitués du microcircuit et de contacts extérieurs, au moyen d'une résine dans laquelle sont noyés les composants, sans que cela implique de remplir totalement la cavité.

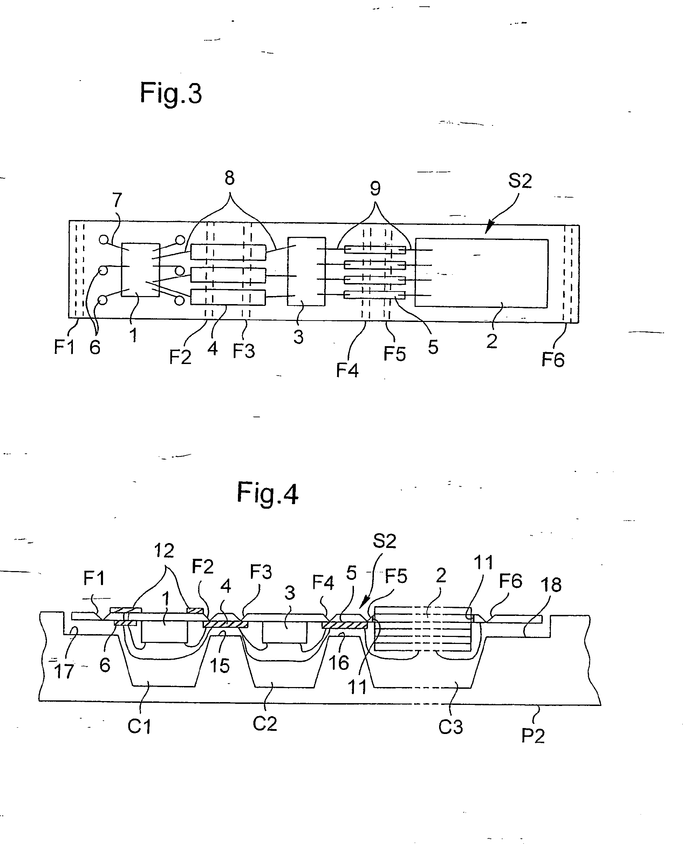

Toutefois, ainsi que cela ressort des figures 3 à 6, le sous-ensemble est avantageusement, en variante, monté dans une pluralité de cavités ménagées dans le support de-carte P2.

Dans cette variante, le sous-ensemble S2 a la même-structure que le sous-ensemble S1 des figures 1 et 2, à ceci près que des fentes de pliage transversales sont ménagées dans l'épaisseur du film support 10.

Ces fentes de pliage sont avantageusement ménagées à distance des composants 1, 2 et 3. C'est ainsi que, dans l'exemple considéré, il y a deux fentes F1 et F2 de part et d'autre du microcircuit 1, deux fentes F3 et F4 de part et d'autre du composant d'interface 3 et deux fentes F5 et F6 de part et d'autre du composant débouchant 2. Ces fentes définissent des zones mécaniquement affaiblies en flexion, surtout lorsqu'elles forment une paire (F2+F3, F4+F5).

Ces fentes sont ici en forme de V et sont, par clarté, représentées comme s'étendant sur toute l'épaisseur du film support 10. Il faut néanmoins bien comprendre que d'autres formes sont possibles (créneau, etc...) et qu'elles ne s'étendent de préférence que sur une partie seulement de l'épaisseur du film support pour en maintenir la continuité.

On peut noter que les fentes F2 et F3 s'étendent au travers des pistes de connexion 4, tandis que les fentes F4 et F5 s'étendent au travers des pistes de connexion 5.

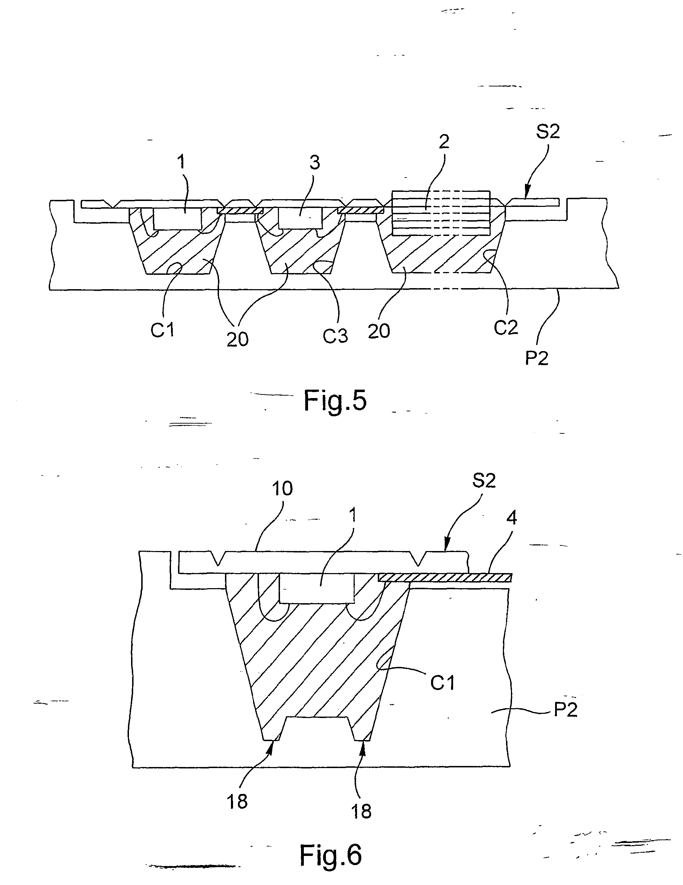

Il ressort des figures 4 et 5, sur lesquelles l'échelle de la figure 3 n'est pas respectée pour des raisons de lisibilité, qu'une cavité est ménagée dans le support de carte sous chaque composant, entre les rentes encadrant ce composant. C'est ainsi que le support de carte P2 comporte un logement comportant une cavité C1 pour le microcircuit 1, une cavité C2 pour le composant débouchant 2 et une cavité C3 pour le composant d'interface.

En variante non représentée, une même cavité peut être prévue pour deux composants, tandis que, pour un même composant ayant une certaine flexibilité, il peut y avoir deux (ou plus) cavités.

On peut noter que, dans l'exemple représenté, les pistes de connexion 4 et 5 surplombent ainsi les nervures 15 et 16 séparant -respectivement les cavités C1 et C3, et les cavités C3 et C2, en débordant de part et d'autre de chacune d'entre elles ; des plateaux 17 et 18 sont en outre ménagés aux extrémités du logement, à côté des cavités C1 et C3 respectivement, en dessous des fentes F1 et F6.

Sur la figure 4 sont représentées de manière schématique le microcircuit 1, les composants 2 et 3, les pistes de connexion 4 et 5, ainsi qu'un plot de connexion 6 et deux contacts extérieurs 12 ; les fils de connexion sont de même représentés de manière schématique (y compris d'éventuels fils contournant l'élément considéré), sans prétendre visualiser toutes les connexions réalisées. On peut toutefois noter que chaque composant est au moins en partie contenu dans une cavité spécifique, les connexions entre cavités étant réalisées par les pistes de connexion. Dans la variante considérée ci-dessus dans laquelle les pistes seraient omises, il faudrait prévoir que les fils soient suffisamment longs pour pouvoir passer au-dessus des nervures 15 et 16.

On peut en outre noter sur cette figure 4 que le composant débouchant 2 est formé d'un empilement de couches dont certaines viennent en saillie hors du logement ; toutefois, le composant peut bien sûr être entièrement contenu dans le logement du support de carte P2. Par ailleurs toutes ces couches sont représentées comme ayant la même dimension, mais elles ont avantageusement en pratique des dimensions différentes avec des couches internes qui sont plus grandes que des couches disposées à l'extérieur de celles-ci, grâce à quoi les couches internes peuvent servir à la fixation mécanique du composant au film support (par collage ou tout autre moyen approprié).

Une résine d'encapsulation peut être appliquée sur chaque composant avant fixation dans le logement du support de carte mais, de manière préférée, une telle résine d'encapsulation est disposée dans chaque cavité avant mise en place du sous-ensemble. On peut ici se référer aux enseignements des documents EP - 1 050 844 (ou US-6 372 541) et EP - 1 050 845, ou encore EP - 0 519 564 (ou US-5 585 669 ou US-5 438750).

De manière avantageuse, ainsi que cela ressort de la figure 5, la résine d'encapsulation remplit complètement les cavités, sans toutefois recouvrir (en tout cas pas complètement) ni les plateaux ni le sommet des nervures. Il en résulte que la résine d'encapsulation, désignée par la référence 20, adhère au fond de la cavité en créant dans chaque cavité des blocs (ou chaînons) rigides constitués de la cavité, du composant qui y est disposé avec la quantité de résine qui l'enrobe et de la portion de film support située entre les deux fentes qui encadrent la cavité considérée. Par contre, l'espace entre les blocs, c'est à dire entre les fentes F2 et F3, F4 et F5, ou les extrémités du film support, à l'extérieur des fentes F1 et F6, constituent des charnières dans lesquelles seront localisés les éventuels efforts de flexion que la carte pourra subir en service, ce qui minimisera les contraintes subies en service par les composants. On obtient ainsi une carte dotée d'une certaine flexibilité sans pour autant solliciter les composants eux-mêmes.

On peut noter que les fentes F1 à F6 sont ici parallèles et transversales à la plus grand dimension du film support.

En variante non représentée, d'autres zones mécaniquement affaiblies en flexion sont ménagées dans le film support transversalement (par exemple perpendiculairement) aux fentes F1 à F6. Cela peut notamment être utile lorsque les composants ne sont pas disposés sur une seule ligne mais en un réseau à deux dimensions (perpendiculaires ou non), des fentes étant disposées selon chacune des directions, de préférence à l'écart des composants.

Selon encore un autre mode de réalisation non représenté, les fentes F1 à F6 sont inclinées selon des angles différents avec, par exemple, les fentes F2 et F3 qui sont toutes deux inclinées vers le haut à droite et les fentes F4 et F5 qui sont toutes inclinées vers le haut à gauche. De la sorte, selon le régime instantané de sollicitations, l'effet de charnière sera principalement localisé dans les fentes F1 et F6, ou dans les fentes F2 et F3 ou dans les fentes F4 et F5.

Selon la variante de la figure 6, le fond des cavités est, non pas complètement plan, mais muni d'une dépression 18 (une gorge périphérique ou d'une succession de creux), ce qui a l'avantage de-localiser les contraintes sur la périphérie du fond de ces cavités.

Le support de carte subit à cet endroit de fortes contraintes, ce qui soulage d'autant les autres zones. Toutefois, pour minimiser les risques de cassure, on réalise avantageusement le support de carte en polymère résistant tel que le PC (polycarbonate) ou le PETF (polyéthylène téréphtalate rendu cristallin par étirement).

Il est à noter que la fabrication de cette carte à puce comporte ainsi les étapes suivantes
- assemblage d'unsous-ensemble S1 ou S2 par montage sur un film support 10 des divers composants (microcircuit, composant débouchant et éventuels pilotes), par exemple par collage ou par adhésif, en ménageant dans ce film une fenêtre pour l'accès (au moins visuel) au composant débouchant, et en assurant les connexions au moyen de fils de connexion, ce film support étant de préférence muni de fentes de flexion entre chaque composant,
- aménagement d'un logement (C1+C2+C3) dans le support de carte, avantageusement formé d'autant de cavités qu'il y a de composants,
- fixation du sous-ensemble dans le logement, en fixant avantageusement chacun des composants dans une cavité du logement, cette fixation se faisant de préférence au moyen d'une résine d'encapsulation remplissant chaque cavité du logement.

Il peut être noté que le sous-ensemble peut facilement être réalisé par les équipements standards de collage et de soudure filaire classiquement utilisés pour la réalisation des modules de cartes à puce simplement constitués d'un microcircuit et de ses contacts extérieurs ; il peut ensuite facilement être mis en place au moyen des moyens classiques de mise en place de tels modules "simples".

La fenêtre ménagée dans le film support n'empêche pas que le composant débouchant soit recouvert d'un film transparent pour sa protection.

## Revendications

1. Carte à puce comportant un microcircuit, au moins un autre composant dont un composant débouchant et des contacts extérieurs dans un support de carte, **caractérisée en ce que** le microcircuit (1), le composant débouchant (2) et les contacts extérieurs (12) font partie d'un sous-ensemble (S1, S2) fixé- dans un logement (C1+C2+C3) ménagé dans une partie de l'épaisseur du support de carte, ce sous-ensemble comportant un film support (10) portant sur une face interne le microcircuit (1) et au moins le composant débouchant (2) et sur une face externe les contacts extérieurs (12), une fenêtre étant ménagée dans ce film support en regard d'une partie du composant débouchant.

2. Carte à puce selon la revendication 1, **caractérisée en ce que** le sous-ensemble comporte en outre un composant d'interface (3) connecté entre le microcircuit (1) et le composant débouchant (2).

3. Carte à puce selon la revendication 2, **caractérisée en ce que** le composant d'interface est un pilote pour le composant débouchant.

4. Carte à puce selon l'une quelconque des revendications 1 à 3, **caractérisée en ce que** les connexions au sein du sous-ensemble sont réalisées par des fils de connexion (7, 8, 9).

5. Carte à puce selon la revendication 4, **caractérisée en ce que** les fils de connexion sont chacun fixés, d'une part, au microcircuit (1) ou à un composant (2, 3), d'autre part, à une piste de connexion (4, 5) portée par le film support.

6. Carte à puce selon l'une quelconque des revendications 1 à 5, **caractérisée en ce que** le logement comporte au moins une cavité (C1) dans laquelle est fixée le microcircuit (1) et une cavité (C2) dans laquelle est fixé le composant débouchant (2), au moins une nervure (15, 16) étant prévue entre les cavités.

7. Carte à puce selon la revendication 6, **caractérisée en ce que** le film support comporte une zone mécaniquement affaiblie en flexion entre au moins le microcircuit et un composant, adaptée à porter contre une nervure.

8. Carte à puce selon la revendication 7, **caractérisée en ce qu'**une zone mécaniquement affaiblie est ménagée de part et d'autre du microcircuit et de chaque composant.

9. Carte à puce selon la revendication 7 ou la revendication 8, **caractérisée en ce que** chaque zone mécaniquement affaiblie comporte au moins une fente (F1 à F6).

10. Carte à puce selon l'une quelconque des revendications 6 à 9, **caractérisée en ce que** des pistes de connexion (4, 5) sont ménagées entre le microcircuit et chaque composant, chacune en regard d'une nervure, chaque piste étant traversée par au moins une zone mécaniquement affaiblie.

11. Carte à puce selon l'une quelconque des revendications 6 à 10, **caractérisée en ce que** chaque cavité est remplie d'un matériau rigide contenant le microcircuit ou un composant et s'étendant jusqu'au film support.

12. Carte à puce selon la revendication 9, **caractérisée en ce que** chaque cavité est munie à la périphérie de son fond d'au moins une dépression (18).

13. Procédé de fabrication d'une carte à puce comportant un microcircuit et au moins un autre composant dont un composant débouchant, comportant les étapes suivantes :
- assemblage d'un sous-ensemble (S1, S2) par montage sur un film support (10)-du microcircuit (1) et d'au moins le composant débouchant (2), en ménageant dans ce film une fenêtre (11) pour l'accès au composant débouchant, et en assurant les connexions au moyen de fils de connexion,
- aménagement d'un logement (C1+C2+C3) dans le support de carte,
- fixation du sous-ensemble dans le logement.

14. Procédé selon la revendication 13, **caractérisé en ce que** on aménage dans le logement une cavité (C1) pour le microcircuit (1) et une cavité (C2) pour le composant débouchant (2).

15. Procédé selon la revendication 14, **caractérisé en ce que** on aménage dans le film support des zones mécaniquement affaiblies en flexion (F2, F3, F4, F5) au moins entre le microcircuit et le composant débouchant.

16. -Procédé selon la revendication 15, **caractérisé en ce que** on aménage dans le film support des zones mécaniquement affaiblies en flexion de part et d'autre du microcircuit et de chaque composant.

17. Procédé selon la revendication 15 ou la revendication 16, **caractérisé en ce que** on aménage les zones mécaniquement affaiblies en flexion au moyen de fentes (F1,..., F6).

18. Procédé selon l'une quelconque des revendications 14 à 17, **caractérisé en ce qu'**au moins une zone mécaniquement affaiblie en flexion est disposée en regard d'une nervure (15, 16) ménagée dans le logement entre deux cavités.

19. Procédé selon l'une quelconque des revendications 14 à 18, **caractérise en ce que** des pistes de connexion (4, 5) connectées au moyen de fils au microcircuit ou à un composant sont traversées par les zones mécaniquement affaiblies en flexion.

20. Procédé selon l'une quelconque des revendications 14 à 19, **caractérisé en ce qu'**au moins une dépression (18) est ménagée à la périphérie du fond d'au moins une cavité.

## Claims

1. Smart card including a microcircuit, one or more other components, including an accessible component, and external contacts in a card support, **characterized in that** the microcircuit (1), the accessible component (2) and the external contacts (12) form part of a subassembly (S1, S2) fixed in a housing (C1+C2+C3) formed in a portion of the thickness of the card support, that subassembly including a support film (10) carrying on an internal face the microcircuit (1) and at least the accessible component (2) and on an external face the external contacts (12), a window being formed in the support film facing a portion of the accessible component.

2. Smart card according to Claim 1, **characterized in that** the subassembly further includes an interface component (3) connected between the microcircuit (1) and the accessible component (2).

3. Smart card according to Claim 2, **characterized in that** the interface component is a controller for the accessible component.

4. Smart card according to any one of Claims 1 to 3, **characterized in that** the connections within the subassembly are made by connecting wires (7, 8, 9).

5. Smart card according to Claim 4, **characterized in that** each connecting wire is connected, firstly, to the microcircuit (1) or to a component (2, 3), and, secondly, to a connecting track (4, 5) carried by the support film.

6. Smart card according to any one of Claims 1 to 5, **characterized in that** the housing includes at least one cavity (C1) in which the microcircuit (1) is fixed and one cavity (C2) in which the accessible component (2) is fixed, at least one rib (15, 16) being provided between the cavities.

7. Smart card according to Claim 6, **characterized in that** the support film includes an area mechanically weakened in bending between at least the microcircuit and a component and adapted to bear against a rib.

8. Smart card according to Claim 7, **characterized in that** a mechanically weakened area is formed on either side of the microcircuit and of each component.

9. Smart card according to Claim 7 or Claim 8, **characterized in that** each mechanically weakened area includes at least one slot (F1 to F6).

10. Smart card according to any one of Claims 6 to 9, **characterized in that** connecting tracks (4, 5) are formed between the microcircuit and each component, each track facing a rib and being crossed by at least one mechanically weakened area.

11. Smart card according to any one of Claims 6 to 10, **characterized in that** each cavity is filled with a rigid material containing the microcircuit or a component and extending as far as the support film.

12. Smart card according to Claim 9, **characterized in that** each cavity is provided at the periphery of its bottom with at least one depression (18).

13. Method of fabricating a smart card including a microcircuit and at least one other component including an accessible component, the method including the following steps:
- assembling a subassembly (S1 or S2) by mounting on a support film (10) the microcircuit (1) and at least the accessible component (2), providing in the film a window (11) for access to the accessible component, and making the connections by means of connecting wires,
- forming a housing (C1+C2+C3) in the card support,
- fixing the subassembly in the housing.

14. Method according to Claim 13, **characterized in that** a cavity (C1) for the microcircuit (1) and a cavity (C2) for the accessible component (2) are formed in the housing.

15. Method according to Claim 14, **characterized in that** areas mechanically weakened in bending (F2, F3, F4, F5) are formed in the support film at least between the microcircuit and the accessible component.

16. Method according to Claim 15, **characterized in that** areas mechanically weakened in bending are formed in the support film on either side of the microcircuit and of each component.

17. Method according to Claim 15 or Claim 16, **characterized in that** the areas mechanically weakened in bending are formed by slots (F1, ..., F6).

18. Method according to any one of Claims 14 to 17, **characterized in that** at least one area mechanically weakened in bending is disposed facing a rib (15, 16) formed in the housing between two cavities.

19. Method according to any one of Claims 14 to 18, **characterized in that** connecting tracks (4, 5) connected by wires to the microcircuit or to a component are crossed by the areas mechanically weakened in bending.

20. Method according to any one of Claims 14 to 19, **characterized in that** at least one depression (18) is formed at the periphery of the bottom of at least one cavity.

## Patentansprüche

1. Chipkarte mit einem Mikroschaltkreis, mindestens einem anderen Bauelement, darunter ein auftauchendes bzw. sich Öffnung verschaffendes bzw. mündendes Bauelement, und äußeren Kontaktstellen in einem Kartenträger, **dadurch gekennzeichnet, dass** der Mikroschaltkreis (1), das auftauchende Bauelement (2) und die äußeren Kontaktstellen (12) Teil einer Untereinheit (S1, S2) sind, die in einem dicken Teil des Kartenträgers ausgebildeten Aufnahme (C1+C2+C3) fixiert ist, wobei diese Untereinheit einen Trägerfilm (10) aufweist, der auf einer inneren Seite des Mikroschaltkreises (1) und zumindest das auftauchende Bauelement (2) und auf der äußeren Seite die äußeren Kontaktstellen (12) trägt, wobei auf diesem Trägerfilm ein Fenster in Richtung eines Teils des auftauchenden Bauelements ausgebildet ist.

2. Chipkarte nach Anspruch 1, **dadurch gekennzeichnet, dass** die Untereinheit zusätzlich ein Zwischenelement bzw. Verbindungselement (3) zwischen dem Mikroschaltkreis (1) und dem auftauchenden Bauelement (2) enthält.

3. Chipkarte nach Anspruch 2, **dadurch gekennzeichnet, dass** das Verbindungselement ein Führungsstück für das auftauchende Bauelement darstellt.

4. Chipkarte nach einem der Ansprüche 1 bis 3, **dadurch gekennzeichnet, dass** die Verbindungen innerhalb der Untereinheit durch Verbindungsdrähte (7, 8, 9) ausgebildet werden.

5. Chipkarte nach Anspruch 4, **dadurch gekennzeichnet, dass** jeder Verbindungsdraht einerseits an dem Mikroschaltkreis (1) oder einem Bauelement (2, 3) und andererseits an einer von dem Trägerfilm getragenen Verbindungsfläche bzw. -leiter bzw. -bahnen (4, 5) fixiert ist.

6. Chipkarte nach einem der Ansprüche 1 bis 5, **dadurch gekennzeichnet, dass** die Aufnahme mindestens eine Vertiefung bzw. Hohlraum (C1), in dem der Mikroschaltkreis (1) fixiert ist, und einen Hohlraum (C2) aufweist, in dem das auftauchende Bauelement (2) fixiert ist, wobei mindestens eine Rippe bzw. Vertiefung (15, 16) zwischen den Hohlräumen vorgesehen ist.

7. Chipkarte nach Anspruch 6, **dadurch gekennzeichnet, dass** der Trägerfilm zumindest zwischen dem Mikroschaltkreis und einem Bauelement eine bezüglich Biegung mechanisch abgeschwächte Zone enthält, die dazu geeignet ist, gegen eine Rippe bzw. Vertiefung zu stoßen bzw. zu dieser zu reichen.

8. Chipkarte nach Anspruch 7, **dadurch gekennzeichnet, dass** eine mechanisch abgeschwächte Zone an beiden Seiten des Mikroschaltkreises und jedes Bauelements angebracht ist.

9. Chipkarte nach Anspruch 7 oder 8, **dadurch gekennzeichnet, dass** jede mechanisch abgeschwächte Zone mindestens einen Spalt (F1 bis F6) aufweist.

10. Chipkarte nach einem der Ansprüche 6 bis 9, **dadurch gekennzeichnet, dass** die Verbindungsflächen bzw. -bahnen (4, 5) zwischen dem Mikroschaltkreis und jedem Bauelement angebracht sind, wobei jede in Richtung einer Rippe bzw. Vertiefung zeigt, wobei jede Fläche bzw. Bahn von mindestens einer mechanisch abgeschwächten Zone gekreuzt wird.

11. Chipkarte nach einem der Ansprüche 6 bis 10, **dadurch gekennzeichnet, dass** jeder Hohlraum mit einem festen bzw. steifen Material gefüllt ist, und zwar den Mikroschaltkreis oder ein Bauelement enthaltend und sich bis zum Trägerfilm erstreckend.

12. Chipkarte nach Anspruch 9, **dadurch gekennzeichnet, dass** jeder Hohlraum in der Peripherie seines Bodens mindestens eine Absenkung bzw. Vertiefung (18) aufweist.

13. Herstellungsverfahren einer Chipkarte mit einem Mikroschaltkreis und mindestens einem weiteren Bauelement, darunter ein auftauchendes bzw. sich Öffnung verschaffendes bzw. mündendes Bauelement, das folgende Verfahrensschritte umfaßt:
- Zusammenfügen einer Untereinheit (S1, S2) durch Montage des Mikroschaltkreises (1) und zumindest des auftauchenden Bauelements (2) auf einem Trägerfilm (10), indem in dem Film ein Fenster (11) als Zugang zum auftauchenden Bauelement ausgebildet wird und indem die Verbindungen mittels Verbindungsdrähten gewährleistet werden,
- Ausbilden von Aufnahmen (C1+C2+C3) in dem Kartenträger,
- Fixierung der Untereinheit in den Aufnahmen.

14. Verfahren nach Anspruch 13, **dadurch gekennzeichnet, dass** man in der Aufnahme einen Hohlraum (C1) für den Mikroschaltkreis (1) und einen Hohlraum (C2) für das auftauchende Bauelement (2) ausbildet.

15. Verfahren nach Anspruch 14, **dadurch gekennzeichnet, dass** man auf dem Trägerfilm bezüglich Biegung mechanisch abgeschwächte Zonen (F2, F3, F4, F5), zumindest zwischen dem Mikroschaltkreis und dem auftauchenden Bauelement, ausbildet.

16. Verfahren nach Anspruch 15, **dadurch gekennzeichnet, dass** man auf dem Trägerfilm bezüglich Biegung mechanisch abgeschwächte Zonen auf beiden Seiten des Mikroschaltkreises und jedes Bauelements ausbildet.

17. Verfahren nach Anspruch 15 oder 16, **dadurch gekennzeichnet, dass** man die bezüglich Biegung mechanisch abgeschwächten Zonen mittels Spalte (F1, ..., F6) ausbildet.

18. Verfahren nach einem der Ansprüche 14 bis 17, **dadurch gekennzeichnet, dass** mindestens eine bezüglich Biegung mechanisch abgeschwächte Zone in Richtung einer Rippe bzw. Vertiefung (15, 16) angeordnet ist, und zwar in der Aufnahme zwischen zwei Hohlräumen.

19. Verfahren nach einem der Ansprüche 14 bis 18, **dadurch gekennzeichnet, dass** Verbindungsflächen bzw. -leiter bzw. -bahnen (4, 5), die mittels Drähten mit dem Mikroschaltkreis oder einem Bauelement verbunden sind, von den bezüglich Biegung mechanisch abgeschwächten Zonen gekreuzt werden.

20. Verfahren nach einem der Ansprüche 14 bis 19, **dadurch gekennzeichnet, dass** mindestens eine Absenkung bzw. Vertiefung (18) an der Peripherie des Bodens von mindestens einem Hohlraum ausgebildet ist.
